# DEMANDE DE BREVET EUROPEEN

(11) **EP 1 122 881 A1**
(43) Date de publication de la demande: **08.08.2001**
(21) Numéro de dépôt: 01410009.3
(22) Date de dépôt: 26.01.2001
(51) Int. Cl.: H03F 3/19

(54) **Préamplicateur vidéo**

(30) Priorité: 31.01.2000 FR 0001213
(71) Demandeur: STMicroelectronics S.A., 94250 Gentilly (FR)
(72) Inventeur: Blanc, Jean-Pierre, 38570 Theys (FR); Barou, Michel, 38340 Voreppe (FR)
(74) Mandataire: de Beaumont, Michel

(57) **Abrégé**

L'invention concerne un préamplificateur comprenant un étage d'entrée propre à recevoir un signal analogique (Vin) par l'intermédiaire d'un condensateur de liaison, un étage de sortie différentiel propre à délivrer ledit signal référencé par rapport à un niveau prédéterminé, et des moyens pour permettre à l'étage d'entrée (30) d'accepter un signal référencé à la masse de l'étage différentiel, le signal délivré par l'étage de sortie étant référencé à cette masse.

## Description

La présente invention concerne le domaine de l'affichage d'images vidéo et, plus particulièrement, un préamplificateur de signaux vidéo destiné à être intercalé entre une source de signal vidéo composite (RGB + signaux de synchronisation) et un amplificateur de signaux à destination d'un moniteur. Le préamplificateur auquel se rapporte l'invention est destiné à recevoir des signaux analogiques.

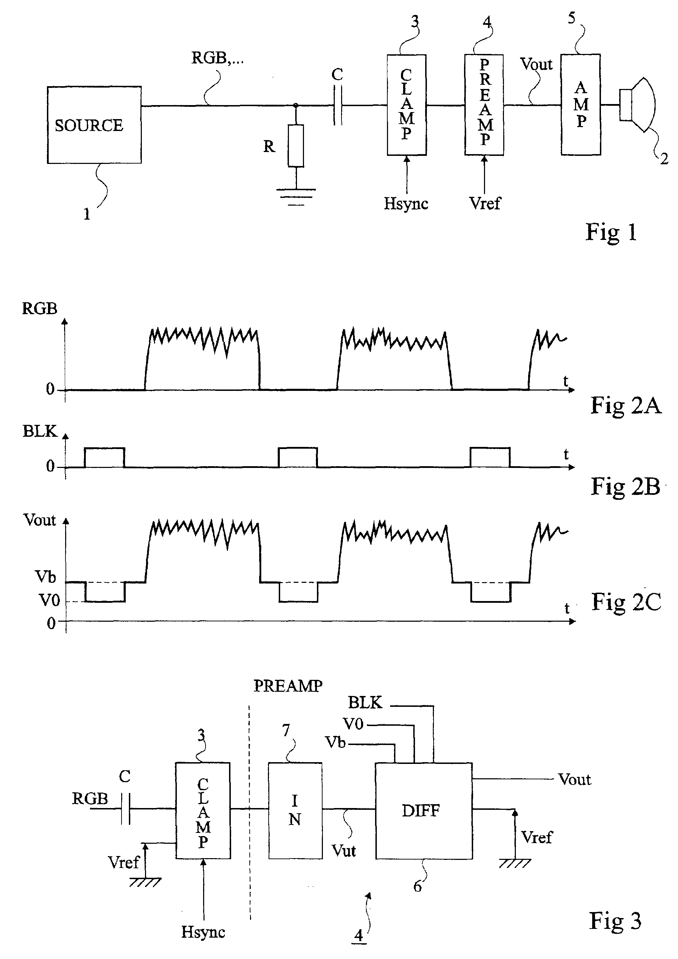

La figure 1 représente, de façon très schématique, un exemple classique de circuit d'affichage vidéo comprenant un préamplificateur du type auquel se rapporte la présente invention. Une source 1 (SOURCE) vidéo constituée, par exemple, d'une carte graphique d'un micro-ordinateur délivre des signaux vidéo à destination d'un moniteur d'affichage. Les signaux délivrés par la source 1 sont essentiellement constitués d'un signal vidéo comprenant les trois informations RGB de composantes couleurs, de signaux de synchronisation et d'un signal (BLK) dit de "blanking" pour fixer un niveau de référence entre deux fenêtres d'affichage. Avant de pouvoir être affichés sur un écran 2 d'un moniteur en étant exploité par les circuits de traitement de ce moniteur, les signaux vidéo doivent subir un traitement analogique comprenant généralement, successivement, un décalage de niveau dans un circuit 3 (CLAMP), une préamplification au sein d'un circuit 4 (PREAMP) et enfin une amplification dans un circuit 5 (AMP). Le rôle de l'amplificateur 5 est uniquement d'apporter du gain au signal vidéo en fin de traitement par les circuits 3 et 4. Le rôle du préamplificateur 4 est, outre de préamplifier le signal vidéo (le gain de l'amplificateur 5 n'étant pas suffisant), de fixer le niveau de base du signal vidéo. Le rôle du circuit 3 de mise en forme est de régler le niveau de tension du signal vidéo pour lui permettre d'attaquer le préamplificateur. Ce réglage s'effectue, hors des fenêtres d'affichage, par exemple, pendant les retours lignes et trames. Le circuit 3 reçoit à cette fin le signal Hsync de synchronisation de retour ligne et de retour trame. Le préamplificateur 4 reçoit un niveau de tension de référence qui dépend de la référence du signal vidéo en entrée de ce préamplificateur comme on le verra par la suite. On notera que les signaux vidéo RGB transitent par un condensateur C de liaison pour isoler la source 1 du reste du moniteur. Les circuits 3, 4 et 5 font partie des traitements analogiques classiques d'un moniteur vidéo. Généralement, l'impédance d'entrée du moniteur est normalisée et fixée par une résistance (R) entre une première électrode du condensateur C et la masse. On notera que d'autres signaux que le signal RGB sont fournis au moniteur.

Les différents traitements analogiques du moniteur au sein des circuits 3, 4 et 5 ont pour fonction principale, en plus d'une amplification du signal, d'assurer l'alignement du signal vidéo et de transmettre la vidéo de façon analogique. Plus particulièrement, le préamplificateur 4 a, outre la fonction d'amplifier le signal en raison du gain insuffisant de l'amplificateur 5, celui de fixer un niveau Vb dit de noir du signal vidéo ainsi qu'un signal V0 de ce signal pendant les périodes de retour trame et de retour ligne.

Les figures 2A, 2B et 2C illustrent, sous forme de chronogrammes schématiques et de façon simplifiée, un exemple de fonctionnement d'un circuit de traitement analogique d'un moniteur vidéo tel qu'illustré par la figure 1. La figure 2A représente un exemple d'allure de signal RGB constitué de niveaux analogiques de tension pendant des fenêtres d'affichage situées entre deux retours ligne. La figure 2B représente l'allure d'un signal BLK de "blanking" comprenant des impulsions entre deux fenêtres d'affichage. En figure 2B, on suppose que tous les paliers (impulsions) du signal BLK ont lieu pendant des retours lignes (ou des retours trames) ayant des durées généralement plus longues. La figure 2C illustre un exemple d'allure du signal Vout délivré par le préamplificateur 4. Ce signal Vout reproduit les niveaux analogiques du signal RGB désormais alignés sur le niveau de noir Vb et mélangés aux paliers du signal BLK qui sont restitués dans un niveau V0.

Les niveaux Vb et V0 sont réglés au sein du préamplificateur 4 pour fixer les niveaux des informations constantes de commande du moniteur. En particulier, comme cela a été indiqué précédemment, le niveau Vb fixe le niveau de noir du moniteur.

Le fonctionnement des circuits du moniteur étant parfaitement connu, il ne sera pas détaillé plus avant. On s'est contenté de faire ressortir les éléments qui permettront ultérieurement de mieux comprendre un exemple d'application de l'invention et ses avantages.

La figure 3 représente, toujours de façon schématique et sous forme de blocs, la partie du circuit de traitement analogique de la figure 1 plus particulièrement associée à l'étage d'entrée du préamplificateur vidéo. Comme l'illustre la figure 3, un préamplificateur (4, figure 1) est essentiellement constitué d'un étage différentiel 6 (DIFF) délivrant le signal Vout et recevant, en entrées différentielles, le niveau de référence Vref et un signal Vut issu d'un étage d'entrée 7 (IN) du préamplificateur. L'étage d'entrée 7 a en particulier pour rôle d'adapter le niveau du signal d'entrée à l'impédance d'entrée de l'étage 6. L'étage d'entrée 7 reçoit le signal vidéo RGB du circuit de mise en forme 3 dont le rôle est de placer le niveau du signal d'entrée du préamplificateur à la tension Vref quand le signal vidéo est à l'état bas, c'est-à-dire pendant les périodes des impulsions de synchronisations horizontales (signal Hsync), donc de placer l'entrée au niveau de référence en dehors des fenêtres d'affichage. Comme l'illustre la figure 3, le circuit différentiel 6 reçoit les informations de niveau Vb, V0 ainsi que le signal BLK qui doit être combiné au signal RGB pour constituer le signal Vout.

L'étage d'entrée 7 d'un préamplificateur vidéo constitue une partie du signal particulièrement délicate à réaliser. En effet, il s'agit du premier maillon d'une chaîne de traitement analogique qui doit donc présenter de bonnes performances en termes de rapidité et de linéarité. Classiquement, le signal RGB doit être aligné par rapport au niveau Vref pour disposer de chutes de tension suffisantes dans le préamplificateur. On utilise généralement une technologie bipolaire au sein du circuit de mise en forme 3 et de l'étage d'entrée 7. En pratique, on compare le niveau d'entrée par rapport au niveau Vref pour contrôler le passage d'un courant dans un transistor bipolaire du circuit 3, c'est-à-dire pour recharger ou décharger le condensateur C pendant les périodes de synchronisations horizontales Hsync afin de fixer le niveau Vref pendant ces périodes. Un problème qui se pose dans les circuits classiques utilisant les transistors bipolaires est que le besoin de courant important dans le préamplificateur a tendance à décaler le niveau de tension du condensateur C dans la mesure où le courant de base du transistor bipolaire d'attaque de l'étage différentiel n'est pas négligeable. Une solution serait d'augmenter le gain de ce transistor. Toutefois, une augmentation du gain du transistor d'entrée introduit une diminution de sa vitesse de commutation.

Un autre problème des circuits classiques est que, dans le cas d'une disparition du signal de synchronisation, l'interrupteur de mise en forme servant à décharger ou à charger le condensateur C doit être fermé pour que le signal d'entrée soit alors au niveau de référence afin que l'étage différentiel 6 ne détecte pas de différence de niveau par rapport à son autre entrée. L'existence d'un courant de base du transistor provoque une charge du condensateur d'entrée, ce qui entraîne progressivement la transmission d'un niveau d'information blanc à l'amplificateur d'affichage alors que le moniteur doit rester noir.

Il serait souhaitable de pouvoir aligner le signal vidéo RGB d'entrée de l'étage différentiel par rapport à la masse. Cela permettrait, entre autres, d'accélérer la réponse de l'étage du préamplificateur pour une moindre consommation. Dans un circuit classique à transistors bipolaires, une telle solution n'est pas possible car la résistance de fuite qu'il faudrait alors mettre pour décharger le condensateur d'entrée engendrerait une décroissance permanente du niveau de cette charge et, par conséquent, une distorsion du niveau blanc de l'image affichée.

La présente invention vise à proposer un nouveau préamplificateur vidéo qui pallie les inconvénients des systèmes connus et, en particulier, qui permette d'aligner le signal vidéo d'entrée par rapport à la masse.

L'invention vise également à proposer une solution qui préserve la rapidité et la linéarité du préamplificateur.

Plus généralement, l'invention vise à proposer un préamplificateur différentiel comprenant un étage d'entrée devant recevoir un signal analogique par un condensateur de liaison ou d'isolement.

Pour permettre un alignement du signal d'entrée par rapport à la masse, il est nécessaire d'avoir recours à un transistor MOS monté en suiveur en guise d'étage d'entrée du préamplificateur. Le recours à un transistor MOS permet également une commande à courant d'entrée nul ce qui présente un avantage indéniable en terme de tenue en charge du condensateur d'entrée C qui constituait un problème des solutions classiques.

Ainsi, une première caractéristique de la présente invention est de proposer un préamplificateur vidéo comprenant, en étage d'entrée, un transistor PMOS monté en suiveur.

Plus particulièrement, la présente invention prévoit un préamplificateur comprenant un étage d'entrée propre à recevoir un signal analogique par l'intermédiaire d'un condensateur de liaison, et un étage de sortie différentiel propre à délivrer ledit signal référencé par rapport à un niveau prédéterminé, caractérisé en ce qu'il comporte des moyens pour permettre à l'étage d'entrée d'accepter un signal référencé à la masse de l'étage différentiel, le signal délivré par l'étage de sortie étant référencé à cette masse.

Selon un mode de réalisation de la présente invention, l'étage d'entrée comporte un premier transistor MOS dont la grille reçoit ledit signal d'entrée référencé à la masse, en série avec une première source de courant, le point milieu entre ladite source de courant et ledit transistor définissant la borne de sortie de l'étage d'entrée du préamplificateur.

Selon un mode de réalisation de la présente invention, le préamplificateur comporte un moyen de commutation pour tirer à la masse la sortie de l'étage d'entrée.

Selon un mode de réalisation de la présente invention, ledit moyen de commutation est constitué d'un deuxième transistor dont la borne de commande est connectée au drain du premier transistor MOS d'entrée.

Selon un mode de réalisation de la présente invention, le préamplificateur comporte des moyens pour fixer, en statique, la tension grille-source du premier transistor MOS à une valeur prédéterminée.

Selon un mode de réalisation de la présente invention, lesdits moyens sont constitués d'une deuxième source de courant connectée entre le drain du premier transistor MOS et la masse, cette deuxième source étant montée en miroir de courant sur une troisième source de courant dont le courant est fixé par un troisième transistor MOS à tension grille-source constante.

Selon un mode de réalisation de la présente invention, ledit deuxième transistor est un transistor de type NPN ainsi que des transistors constitutifs des deuxième et troisième sources de courant, la première source de courant étant constituée d'un transistor bipolaire de type PNP.

Selon un mode de réalisation de la présente invention, les courants des première et deuxième sources sont liés l'un à l'autre par l'intermédiaire d'un montage de miroirs de courant.

Selon un mode de réalisation de la présente invention, le préamplificateur comporte un condensateur de stabilisation entre la source et le drain du premier transistor MOS.

Selon un mode de réalisation de la présente invention, le préamplificateur est appliqué à un circuit de traitement analogique d'un signal vidéo.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2A, 2B, 2C et 3 qui ont été décrites précédemment sont destinées à exposer l'état de la technique et le problème posé ;
la figure 4 représente, de façon schématique et simplifiée, un mode de réalisation d'un préamplificateur pourvu, en étage d'entrée, d'un transistor PMOS ; et
la figure 5 est un schéma électrique détaillé d'un mode de réalisation d'un étage d'entrée d'un préamplificateur selon la présente invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les structures respectives des circuits de traitement analogique, qu'il s'agisse du circuit de mise en forme en amont du préamplificateur auquel se rapporte l'invention ou de l'amplificateur aval, n'ont pas été détaillées et ne font pas l'objet de la présente invention. De même, les détails constitutifs de l'étage différentiel du préamplificateur de l'invention restent classiques et ne seront pas détaillés. Seul l'étage d'entrée de ce préamplificateur sera exposé de façon détaillée par la suite, l'adaptation éventuelle des autres constituants des circuits de traitement analogique étant à la portée de l'homme du métier.

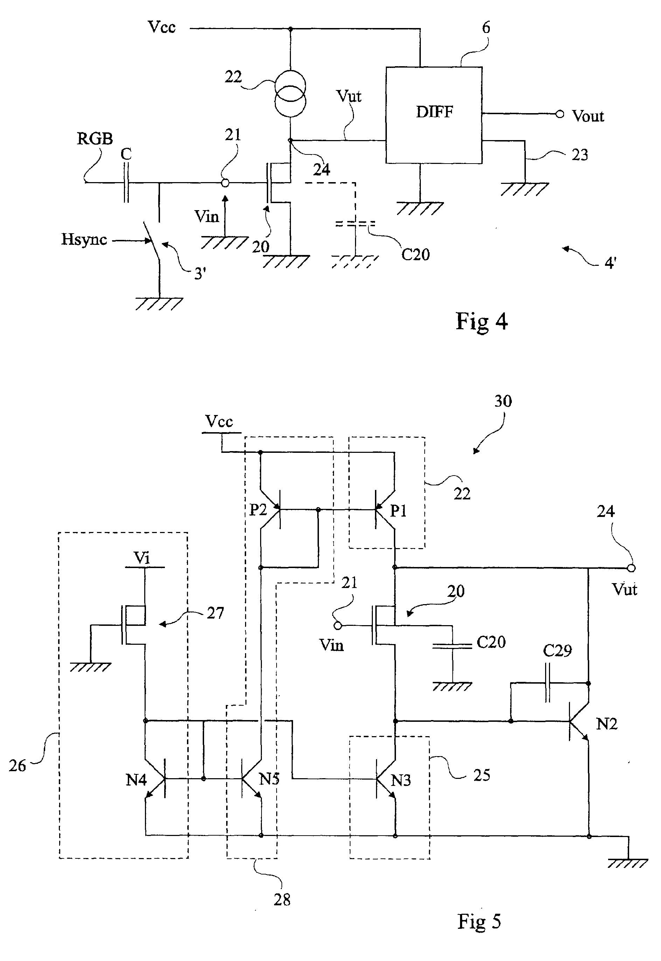

La figure 4 représente, de façon schématique et simplifiée, un préamplificateur 4' d'un signal vidéo comprenant, en guise d'étage d'entrée, un transistor PMOS 20 dont la grille 21 est destinée à recevoir un signal Vin et dont la source délivre un signal utile Vut à destination d'un étage différentiel 6 du préamplificateur. L'étage différentiel 6 est alimenté par une tension Vcc d'alimentation du préamplificateur 4'. Une source de courant 22 relie la source du transistor 20 à la tension Vcc. Le drain du transistor PMOS 20 est connecté à la masse. Comme précédemment, le préamplificateur 4' doit délivrer un signal vidéo Vout du type de celui illustré en figure 2C. Il reçoit donc au moins les niveaux de tension Vb et V0 ainsi que le signal de blanking BLK. Ces signaux n'ont pas été représentés en figure 4 pour des raisons de clarté. On notera que les niveaux de tension Vb et V0 peuvent être rendus disponibles au niveau du préamplificateur 4' soit directement sous forme de références de tension, soit par l'intermédiaire de moyens de réglage (par exemple, potentiométriques) d'une tension de référence.

On notera que, selon l'invention, l'étage différentiel 4' n'a plus besoin d'une entrée de référence à un niveau particulier. En effet, selon l'invention, ce niveau de référence est désormais la masse. Comme on le verra par la suite, on utilisera, de préférence, côté entrée différentielle 23 de référence, un montage similaire à celui qui sera exposé par la suite en relation avec la figure 5 pour des raisons de symétrie du montage.

Comme l'illustre la figure 4, le bloc de mise en forme 3' d'un circuit de l'invention comprend essentiellement un interrupteur cammandé par le signal de synchronisation et cet interrupteur raccorde la borne 21 d'entrée à la masse pendant les périodes où le signal vidéo n'est pas présent. Le transistor 20 est alors passant ce qui ramène le niveau Vut sensiblement à la masse (à la chute de tension grille-source Vgs du transistor 20 près). On notera donc ici un premier avantage de l'invention qui est de préserver un niveau noir du moniteur en l'absence de signal de commande du circuit de mise en forme 3', c'est-à-dire en l'absence de signal de synchronisation. Le circuit 3' est simplifié par rapport à un circuit classique dans la mesure où il n'y a pas besoin de référence de tension autre que la masse.

Un problème qui se pose toutefois avec l'utilisation d'un transistor MOS en étage d'entrée du préamplificateur est lié au fait que cet étage d'entrée fonctionne à courant constant fixé par la source 22. En effet, pour une tension d'entrée nulle (Vin = 0), le courant de la source 22 fixe une tension drain-source dans la caractéristique du transistor MOS 20. Un problème qui se pose alors est qu'une variation de la tension d'entrée Vin se traduit par une variation de la tension grille-source Vgs du transistor 20, ce qui implique que le point de fonctionnement du circuit ne suit pas la caractéristique du courant en fonction de la tension drain-source à Vgs constant. On introduit donc une non-linéarité dans le fonctionnement du transistor. Cette non-linéarité risque d'être préjudiciable en terme de distorsion du signal.

Une première solution serait d'utiliser un canal de longueur suffisamment importante pour rendre la résistance Ro de sortie du transistor 20 en zone saturée (variation de la tension drain-source Vds divisée par la variation du courant Ids dans le transistor) suffisamment grande devant la tension d'entrée. Il serait alors nécessaire d'augmenter également la largeur de la grille afin de limiter l'augmentation de la tension grille-source introduite par un canal de longueur plus importante. Par ailleurs, une augmentation de la longueur du canal et de la largeur de la grille conduit à une augmentation de la capacité présente sur la source du transistor. Une augmentation de cette capacité introduit un ralentissement dans le temps de réponse de l'étage d'entrée, ce qui n'est pas souhaitable pour un préamplificateur rapide. Cette solution conduisant à augmenter à la fois la largeur de la grille et la longueur du canal du transistor n'est pas idéale en ce qu'elle conduit à des dimensions très importantes et par conséquent à une consommation élevée si l'on souhaite préserver les caractéristiques de rapidité et de linéarité de l'étage d'entrée souhaité.

Ainsi, selon une autre caractéristique de la présente invention, on utilise un montage en technologie BICMOS pour pallier au problème d'introduction d'un transistor MOS dans l'étage d'entrée du préamplificateur, sans qu'il soit nécessaire d'en augmenter les dimensions.

On notera que le courant de la source 22 doit être suffisamment élevé afin de pouvoir charger rapidement les capacités présentes sur le noeud de sortie 24 (source du transistor 20). Ces capacités ont été symbolisées en figure 4 par un condensateur C20 en pointillés entre le noeud 24 et la masse. Pour éviter de dégrader les performances du transistor PMOS 20, le substrat du transistor (par exemple, le caisson dans lequel il est réalisé) doit impérativement être relié à sa source. La capacité caisson-substrat (bulk-substrat) du transistor n'est alors pas négligeable sur le noeud de sortie 24 et contribue à la valeur de la capacité C20.

La figure 5 représente un mode de réalisation détaillé d'un étage d'entrée d'un préamplificateur vidéo selon la présente invention, réalisé en technologie BICMOS. Cet étage d'entrée 30 est, comme le montage de la figure 4, basé sur l'utilisation d'un transistor MOS à canal P 20 recevant, sur sa grille 21, le signal d'entrée Vin du préamplificateur référencé à la masse au moyen d'un circuit de mise en forme 3' du type de celui exposé en relation avec la figure 4.

Dans le montage de la figure 5, la capacité C20 symbolisant l'ensemble des capacités du noeud de sortie 24 de l'étage d'entrée a été représentée en traits pleins. Cette capacité symbolise, entre autres, la capacité caisson-substrat du transistor 20, la capacité d'entrée de l'étage différentiel 6 à laquelle est reliée la borne 24, ainsi que les capacités collecteur-substrat des transistors N2 et P1.

Dans la technologie BICMOS mise en oeuvre en figure 5, la source de courant 22 est réalisée sous la forme d'un transistor bipolaire P1 de type PNP dont l'émetteur est connecté à la tension d'alimentation Vcc et dont le collecteur est relié à la source du transistor 20.

Une caractéristique du montage BICMOS de l'invention est d'utiliser un transistor bipolaire N2 de type NPN pour améliorer la rapidité du transistor 20 afin d'accélérer sa réponse impulsionnelle. Ce transistor N2 est connecté entre la borne 24 de sortie et la masse, son émetteur étant connecté à la masse. La base du transistor N2 est connectée au drain du transistor MOS 20. Une source de courant supplémentaire 25 est intercalée entre le drain du transistor 20 (donc la base du transistor N2) et la masse pour permettre, en dynamique, le blocage du transistor N2 comme on le verra par la suite. En statique, la source de courant 25 participe à la fixation de la tension grille-source Vgs du transistor 20. Cette source de courant 25 est, de préférence, constituée d'un transistor bipolaire N3 de type NPN dont le collecteur est relié à la base du transistor N2 et dont l'émetteur est relié à la masse.

De préférence, la tension grille-source du transistor 20 est fixée à une valeur de référence Vi au moyen d'un montage 26 comprenant un transistor bipolaire N4 de type NPN monté en miroir de courant sur le transistor N3 et dont le collecteur est relié au drain d'un transistor MOS à canal P 27. La grille du transistor 27 est connectée à la masse et sa source est reliée à la tension Vi. Le transistor 27 est en permanence passant, sa grille étant reliée à la masse. Son courant est tel que sa tension grille-source est égale à la tension Vi. Ce courant dans le transistor 27 est recopié dans le transistor N3 grâce au montage en miroir de courant du transistor N3 et du transistor N4, les bases des transistors N3 et N4 étant connectées au collecteur du transistor N4 dont l'émetteur est à la masse. Le courant dans le transistor MOS 20 dépend du courant dans le transistor N3 (en négligeant le courant de base du transistor N2). Par conséquent, si les transistors 20 et 27 ont les mêmes dimensions (longueur de canal et largeur de grille), la tension grille-source du transistor 20 sera égale à la tension Vi. Le fait de contrôler la tension grille-source du transistor 20 permet d'optimiser la tension d'alimentation du montage à une tension la plus faible possible, tout en rendant celui-ci insensible à d'éventuelles dispersions technologiques et en température.

Dans le mode de réalisation préféré illustré par la figure 5, le courant de la source 22 est lié au courant de la source 25 grâce à un montage 28, constitué de deux sources de courant en série entre la borne d'application de la tension Vcc et la masse. Ces deux sources de courant sont respectivement montées en miroir sur la source 22 et sur la source 25. Dans l'exemple représenté, le montage 28 est constitué d'un transistor P2 de type PNP en miroir de courant sur le transistor P1, les bases des transistors P1 et P2 étant reliées au collecteur du transistor P2 dont l'émetteur est connecté à la tension Vcc. La source de courant inférieure du montage 28 est constituée d'un transistor N5 de type NPN monté en miroir de courant sur le transistor N3, la base du transistor N5 étant reliée au collecteur du transistor N4 et son émetteur étant connecté à la masse tandis que son collecteur est relié au collecteur du transistor P2. Grâce à un tel montage, le courant dans la source 22 est lié au courant dans la source 25, ce qui évite l'influence des dispersions technologiques sur les courants du préamplificateur de l'invention.

On notera que, dans le cas où le transistor P1 est de taille suffisante pour délivrer assez de courant pour le transistor N3, la capacité C20 et le transistor N2, le montage 28 n'est alors pas nécessaire.

En raison de la rapidité de réponse souhaitée pour le préamplificateur, un condensateur C29 est connecté entre le collecteur et la base du transistor N2 pour stabiliser la boucle que constitue ce transistor avec le transistor 20, et éviter ainsi les oscillations.

Un des rôles du transistor N2 est de décharger la capacité C20 de sortie de l'étage d'entrée du préamplificateur plus rapidement lorsqu'il est rendu conducteur. Un tel fonctionnement se produit, en particulier, en cas d'augmentation du courant drain-source dans le transistor 20, ce qui se produit, en régime transitoire, sous la forme d'une augmentation de sa tension grille-source avant que celle-ci soit restabilisée par le circuit 26. Ainsi, quand la tension Vin diminue, la tension Vout diminue plus lentement ce qui, transitoirement, entraîne une augmentation de la tension grille-source (en valeur absolue) et du courant drain-source du transistor 20 et rend ainsi conducteur le transistor N2 pour décharger plus rapidement la capacité de sortie C20. A l'inverse, quand la tension Vin augmente, la tension au noeud 24 augmente plus lentement en raison de la présence de la capacité C20. De façon transitoire, la tension grille-source du transistor 20 diminue de même que le courant qui le traverse. Comme la source 25 tire un courant fixe prédéterminé, le transistor N2 se bloque par disparition de son courant de base et le courant fixé par la source 22 change rapidement par la capacité C20 du noeud de sortie 24.

On notera que le temps de réponse de la boucle constituée par les transistors 20 et N2 est ajusté par le condensateur C29 en fonction de la capacité C20 de sortie donc, entre autres, du transistor d'entrée de l'étage différentiel (non représenté en figure 5). Le condensateur C29 sert en outre à corriger une éventuelle instabilité introduite par la géométrie du transistor MOS 20 dont les dimensions sont fixées par le fonctionnement du circuit en statique. Dans ce fonctionnement statique, on asservit sa tension grille-source au moyen du montage 26. Cela permet en outre d'éviter que le transistor d'entrée de l'étage différentiel (6, figure 4) se bloque en présence de fortes excursions du signal vidéo.

Bien que cela n'ait pas été représenté aux figures, un montage similaire à celui illustré par la figure 5 est reproduit côté borne 23 d'entrée de référence de l'étage différentiel 6 pour symétriser le montage. La seule distinction par rapport au circuit de la figure 5 est que l'entrée 21 est alors, côté référence 23, reliée à la masse.

Un avantage qu'il y a à pouvoir utiliser un signal d'entrée aligné par rapport à la masse, en particulier dans l'application au signal vidéo est que cet alignement peut être effectué au moyen d'un simple interrupteur, d'où il résulte que le circuit de mise en forme est beaucoup plus simple que dans l'art antérieur.

Un autre avantage est que l'étage d'entrée dispose alors de chutes de tension suffisamment importantes pour permettre l'utilisation du circuit sous une faible tension d'alimentation.

Bien entendu, la présente invention est susceptible de diverses variantes et modifications qui apparaîtront à l'homme de l'art. En particulier, les dimensionnements des différents transistors de l'étage d'entrée du préamplificateur de l'invention seront choisis en fonction des contraintes de fonctionnement statiques et dynamiques de l'application à laquelle le montage est destiné, et ces dimensionnements sont à la portée de l'homme du métier à partir des indications fonctionnelles données ci-dessus. De plus, bien que l'on ait fait référence dans la description qui précède à un montage en technologie BICMOS, on notera que les transistors bipolaires N2, N3, N4 et N5 pourront être remplacés par des transistors MOS à canal N et que les transistors bipolaires P1 et P2 pourront être remplacés par des transistors MOS à canal P. Toutefois, pour le transistor N2, le transistor NMOS de remplacement devra alors respecter la double condition que sa tension grille-source ne soit que légèrement supérieure à sa tension seuil et que, dans la technologie utilisée, la tension seuil des transistors MOS à canal P soit supérieure à celle des transistors à canal N. Sinon, la condition de fonctionnement du circuit avec un transistor N2 bipolaire (Vgs + Vin - Vbe > Vgs Vt, où Vgs est la tension grille-source (en valeur absolue) du transistor 20, Vt sa tension seuil, et Vbe la tension base-émetteur du transistor N2) qui est respectée car la tension seuil Vt du transistor 20 est supérieure à la tension base-émetteur Vbe du transistor N2, ne l'est plus une fois transposée au cas d'un transistor NMOS à la place du transistor N2.

En outre, bien que la présente invention ait été décrite en relation à une application au traitement analogique de signaux vidéo, on notera que le montage préamplificateur rapide et linéaire proposé peut trouver d'autres applications dans lesquelles des problèmes similaires se posent. Par exemple, on pourra souhaiter utiliser un tel montage dans le traitement analogique de signaux autres que vidéo où l'on souhaite allier la rapidité, la linéarité, un courant d'entrée nul et une faible tension d'alimentation.

## Revendications

1. Préamplificateur comprenant un étage d'entrée propre à recevoir un signal analogique (Vin) par l'intermédiaire d'un condensateur de liaison (C), et un étage de sortie différentiel (6) propre à délivrer ledit signal référencé par rapport à un niveau prédéterminé, caractérisé en ce qu'il comporte des moyens pour permettre à l'étage d'entrée (30) d'accepter un signal référencé à la masse de l'étage différentiel, le signal (Vout) délivré par l'étage de sortie étant référencé à cette masse.

2. Préamplificateur selon la revendication 1, caractérisé en ce que l'étage d'entrée (30) comporte un premier transistor MOS (20) dont la grille (21) reçoit ledit signal d'entrée (Vin) référencé à la masse, en série avec une première source de courant (22), le point milieu entre ladite source de courant et ledit transistor définissant la borne (24) de sortie de l'étage d'entrée du préamplificateur.

3. Préamplificateur selon la revendication 2, caractérisé en ce qu'il comporte un moyen (N2) de commutation pour tirer à la masse la sortie (24) de l'étage d'entrée (30).

4. Préamplificateur selon la revendication 3, caractérisé en ce que ledit moyen de commutation est constitué d'un deuxième transistor (N2) dont la borne de commande est connectée au drain du premier transistor MOS d'entrée (20).

5. Préamplificateur selon l'une quelconque des revendications 2 à 4, caractérisé en ce qu'il comporte des moyens (26, 25) pour fixer, en statique, la tension grille-source du premier transistor MOS (20) à une valeur prédéterminée (Vi).

6. Préamplificateur selon la revendication 5, caractérisé en ce que lesdits moyens sont constitués d'une deuxième source de courant (25) connectée entre le drain du premier transistor MOS (20) et la masse, cette deuxième source étant montée en miroir de courant sur une troisième source de courant (N4) dont le courant est fixé par un troisième transistor MOS (27) à tension grille-source constante (Vi).

7. Préamplificateur selon la revendication 6 dans son rattachement à la revendication 4, caractérisé en ce que ledit deuxième transistor (N2) est un transistor de type NPN ainsi que des transistors (N3, N4) constitutifs des deuxième (25) et troisième sources de courant, la première source de courant (22) étant constituée d'un transistor bipolaire (P1) de type PNP.

8. Préamplificateur selon la revendication 6 ou 7, caractérisé en ce que les courants des première (22) et deuxième (25) sources sont liés l'un à l'autre par l'intermédiaire d'un montage de miroirs de courant (28).

9. Préamplificateur selon l'une quelconque des revendications 2 à 8, caractérisé en ce qu'il comporte un condensateur (C29) de stabilisation entre la source et le drain du premier transistor MOS (20).

10. Préamplificateur selon l'une quelconque des revendications 1 à 9, caractérisé en ce qu'il est appliqué à un circuit de traitement analogique d'un signal vidéo.
